(19) Europäisches Patentamt
European Patent Office
Office européen des brevets

(11) EP 0 745 860 A2

(12) EUROPÄISCHE PATENTANMELDUNG

(43) Veröffentlichungstag:
04.12.1996 Patentblatt 1996/49

(51) Int. Cl.$^6$: G01R 17/14

(21) Anmeldenummer: 96106996.0

(22) Anmeldetag: 03.05.1996

(84) Benannte Vertragsstaaten:
DE ES FR GB IT SE

(30) Priorität: 30.05.1995 DE 19519677

(71) Anmelder: TEMIC TELEFUNKEN microelectronic GmbH
74072 Heilbronn (DE)

(72) Erfinder:
• Held, Christian
86529 Schrobenhausen (DE)

• Küblbeck, Hermann
86529 Schrobenhausen (DE)
• Steurer, Helmut
85302 Gerolsbach (DE)
• Wöhrl, Alfons
86529 Schrobenhausen (DE)

(74) Vertreter: Maute, Hans-Jürgen, Dipl.-Ing.
TEMIC TELEFUNKEN microelectronic GmbH
Postfach 35 35
74025 Heilbronn (DE)

(54) **Verfahren zur Reduzierung der Auswirkung von Drift auf Signal-Nullpegel bei Ansteuerungen von Insassen-Schutzsystemen**

(57) Die Erfindung beschreibt ein Verfahren zur Reduzierung der Auswirkung von Drift auf die Signal - Nullpegel bei Ansteuerungen von Insassen-Schutzsystemen. Die Anordnung basiert darauf, daß man hierbei anstelle einer statischen Bezugsspannung eine dynamisch gebildete Spannung als Signal-Nullpegel verwendet, die sich aus der ursprünglich statischen aber von Drift überlagerten Bezugsspannung ergibt. Dieses wird dadurch erreicht, daß Mittelwerte gebildet werden und durch deren Abweichung neue Signal-Nullpegel-Werte dynamisch festgelegt werden.

Voraussetzung für dieses Verfahren ist ein etwas erhöhter Speicherbedarf des Mikroprozessors in der Signalauswerteeinheit sowie etwas zusätzliche Rechenzeit.

FIG. 1

EP 0 745 860 A2

**Beschreibung**

**Die Erfindung betrifft** ein Verfahren zur Reduzierung der Auswirkung von Drift auf die Signal - Nullpegel bei Ansteuerungen von Insassen-Schutzsystemen gemäß dem Oberbegriff des Patentanspruchs 1.

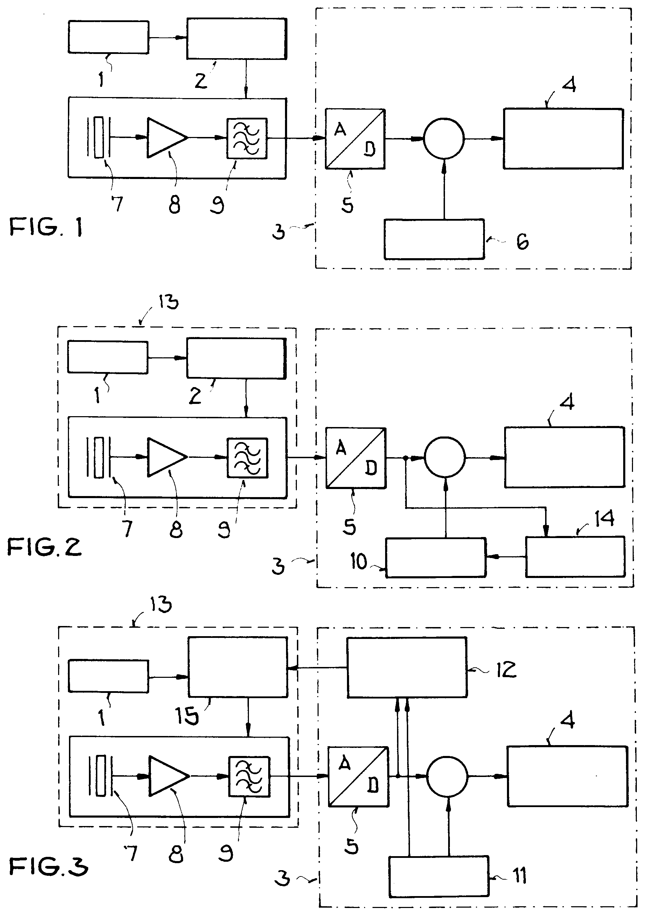

In Kraftfahrzeugen befinden sich Auslösegeräte von Schutzeinrichtungen wie Gurtstraffer und Airbag-Systeme. Über einen Beschleunigungsaufnehmer werden die für eine Auslösung relevanten Daten über einen Analog- Digitalwandler in einem Mikroprozessor mit Speichereinrichtungen ausgewertet und gespeichert. Es ist bekannt, daß in elektronischen Baugruppen mit Signalverarbeitungsanteilen, die aus einer zweipoligen, Spannungsquelle versorgt werden, der Signal-Nullpegel dritten kann. Das ist insbesondere in Baugruppen für den Einsatz in Kraftfahrzeugen wie beispielsweise Airbagsteuergeräten der Fall. Hierbei besteht die Aufgabe eines Airbagsteuergerätes im Kraftfahrzeug darin einen Crashfall zu erkennen und den/die richtigen Zeitpunkt(e) zur Auslösung der Insassenschutzvorrichtung(en) zu bestimmen und die Auslösung auszuführen. Daher muß das Airbagsteuergerät, wie in Fig. 1 dargestellt, die Signatur des Crashvorganges, beispielsweise in Form von Beschleunigungen bzw. Verzögerungen mit einem Beschleunigungsaufnehmer 7 messen und unmittelbar (realtime) auswerten. Die vom Airbagsteuergerät in einer oder mehreren Richtungen gemessenen Crashsignaturkomponente(n) werden intern verstärkt 8 und gefiltert 9 und einer Signalauswerteeinheit 3 zugeführt. Hierbei wird ein Signal-Nullpegel 2 der Signale, die der Signalauswerteeinheit 3 zugeführten werden, definiert. Dieser Signal - Nullpegel 2 kann jedoch vom definierten Wert abweichen, der als statischer Signal-Nullpegel-Sollwert 6 in der Signalauswerteeinheit 3 abgespeichert ist. Dies geschieht aufgrund von Herstelltoleranz und einem Drift 1, der sich aus einer Summe, bestehend aus systematischen Abhängigkeiten von Umwelt- und Betriebsbedingungen und zufallsbedingter Abhängigkeiten, ergibt. Die Signalauswerteeinheit 3 verarbeitet diese Signale nach dem Wandler 5, die mit einer Abweichung des Signal-Nullpegels 2 behafteten sein können unter anderem zu Einfach- oder/und Mehrfachintegralen, aus denen sich der/die Auslösezeitpunkt(e) der Insassenschutzeinrichtung(en) ergibt/ergeben. Deshalb führt eine Abweichung des Signal-Nullpegel-Sollwert 6 vom Signal-Nullpegel 2 zu Ungenauigkeiten bezüglich des Auslösezeitpunkte/s, der wiederum vom eigentlichen Meßwert 4 abhängt. Zum Schutz vor Drifts 1 können bisher niederohmige Referenzspannungsquellen verwendet werden, die als Signal-Nullpegel-Bezug für die Signalverarbeitungsverstärker 3 dienen. Weiterhin werden spezielle driftarme Bauteile zum Einsatz gebracht und die ganze Baugruppe oder zumindest der empfindliche Bereich davon hermetisch dicht verpackt, um den Abfall der Funktionsschutzisolation zu verhindern, welcher Drifts hervorrufen kann.

**Nachteilig an diesen Verfahren ist jedoch,** daß neben der hohen Kosten für driftarme Bauteile diese Maßnahmen nur ursachenselektiv wirksam sind und Fehlerquellen nur jeweils einzeln und mit erheblichem Kosten- und Materialaufwand eingeschränkt werden können.

Auch führt der zufallsbedingte Drift des Signal-Nullpegels über eine längeren Zeitraum hinweg zu Funktionsqualitätseinbußen insbesondere bezüglich der Qualität der/des Auslösezeitpunkte(s) für die Insassenschutzeinrichtung(en).

**Der Erfindung liegt daher die Aufgabe zugrunde** ein Verfahren der eingangs genannten Art zu schaffen bei dem die Auswirkungen von Drift auf Signal - Nullpegel reduziert werden, so daß die Auslösegenauigkeit erhöht wird.

**Diese Aufgabe wird erfindungsgemäß durch die Merkmale des Patentanspruches 1 gelöst.** Hierbei wird anstelle einer statischen Bezugsspannung eine dynamisch gebildete Spannung als Signal-Nullpegel verwendet, die sich aus der ursprünglich statischen aber von Drift überlagerten Bezugsspannung ergibt.

Vorteilhafte Weiterbildungen der Erfindung ergeben sich aus den abhängigen Ansprüchen.

**Die mit der Erfindung erzielten Vorteile bestehen** insbesondere darin, daß im Dynamikbereich die Auswirkungen von Drifts auf ein Minimum reduziert werden und so eine optimale Qualität der/des Auslösezeitpunkte(s) und der Winkelselektivität des Airbagsteuergerätes gewährleistet ist. Die Kosten der Lösung im Seriengerät bestehen nur aus den Kosten eines etwas erhöhten Speicherbedarfes. Nun wird in einer Crashsituation der Airbag oder eine andere Vorrichtung zur schützenden Verzögerung des/der Insassen immer zum richtigen Zeitpunkt (etwa auf eine Millisekunde genau) zur Verfügung stehen. Ein weiterer Vorteil ergibt sich bei komplexeren Rückhaltesystemen (z.B. Knieairbags, Mittelairbags, Seitenairbags, und ähnliche sowie für Kraftfahrzeugtypen, die ungünstig gestaltet sind). Hier ist eine Erfassung der Richtung, aus der ein Crash erfolgt, nötig oder wenigstens hilfreich. Realisiert wird dies in der Regel durch ein winkelselektives Erfassen der Crashsignatur durch ein zwei- oder mehrkanaliges Erfassen der Crashsignatur und geeigneter Signalauswertung. Eine eventuelle Verfälschung des Ruhepegels verfälscht auch die Richtungsinformation und reduziert die Qualität des Auslösegerätes. Bei Einsatz eines erfindungsgemäßen Signal-Nullpegeles wird die Qualität der Winkelselektivität ohne zusätzliche Kosten verbessert. Dadurch erhöht sich die Schutzqualität von Insassenschutzeinrichtungen mit Vorzugs- bzw. winkelselektiver Wirkcharakteristik, da diese von der Genauigkeit der Winkelselektivität des Airbagsteuergerätes abhängig ist.

Im folgenden soll die Erfindung anhand von Ausführungsbeispielen im Zusammenhang mit den Zeichnungen dargestellt und erläutert werden. Es zeigen:

**Figur 1:**    Ablaufdiagramm der bisherigen Lösung mit festem Nullpunkt

**Figur 2:**    Ablaufdiagramm des erfindungsgemäßen Verfahrens mit dynamischem Nullpunkt, der durch eine Mittelung erzeugt wird.

**Figur 3:**     Ablaufdiagramm des erfindungsgemäßen Verfahrens, bei dem die Nullpunktspannung nachgeregelt wird

**Anhand der in Figur 2** beschriebenen Anordnungen wird ein erfindungsgemäßes Verfahren dargestellt, daß zur Reduzierung der Auswirkung von Drift auf Signal - Nullpegel bei Insassen-Schutzsystemen dient. Diese besteht aus einer Signal-Auswerteeinheit **3** und einer Signalquelle **13**. Das in der Signalquelle **13** erzeugte Signal besteht aus zwei Komponenten: einem Grundsignal, das einen Nullpunkt definiert, dem Signal-Nullpegel **2** und dem eigentlichen Wirksignal vom Beschleunigungsaufnehmer **7**. Das Wirksignal wird in einem Verstärker vergrößert **8** und zusammen mit dem Grundsignal **2** gefiltert **9** und dann an die Signalauswerteeinheit **3** weitergeleitet. Das Grundsignal, also der definierte statische Nullpunkt des Systems, kann von Störsignalen dem Drift **1**, die aufgrund von Herstelltoleranzen, Umwelteinflüssen, Betriebsbedingungen und zufallsbedingten Faktoren entstehen, überlagert werden. Am Ausgang der Signalquelle **13** wird das durch den Drift **1** verfälschte Signal an die Signalauswerteeinheit **3** weitergeleitet. Bei dieser Signalauswerteeinheit handelt es sich im wesentlichen um einen Mikroprozessor. Hier wird das Signal in einem Analog/Digital Wandler **5** umgewandelt. Zusammen mit einem dynamischen Signal-Nullpegel **10** entsteht dann ein vorzeichenbehafteter Meßwert **4**, dessen Größe über die weiteren Auslösevorgänge entscheidet. Erfindungsgemäß ist der Signal-Nullpegel **10** in der Signalauswerteeinheit nicht mehr eine feste Größe, die vom Nullpunkt bestimmenden Grundsignal **2** zum Zeitpunkt der Fertigung abhängig ist, sondern kann bei driftbedingten Störungen oder Abweichungen **1** über eine Korrektureinrichtung **14** dynamisch verändert werden. Hierbei werden die Signale in einem bestimmten zeitlichen Abstand nach dem A/D-Wandler abgegriffen. Dann werden diese Werte gemittelt und mit dem vorhergehenden Wert verglichen. Herrscht Übereinstimmung bleibt der dynamische Nullpunkt **10** konstant. Bei einer Abweichung wird der neue Mittelwert als Nullpunkt **10** abgespeichert. Die Basis hierfür ist, daß das Frequenzspektrum des Drifts im Vergleich zum signifikanten Frequenzspektrum von Crashsignaturen sehr niedrig ist, so daß das System deutlich zwischen driftbedingten und beschleunigungsbedingten Veränderungen unterscheiden kann. Der Signal-Nullpegel **10** wird in der Signalauswerteeinheit **3** bei einer Störung ständig neu definiert und paßt sich laufend dem Drift an.

**Figur 3** beschreibt eine weitere erfindungsgemäße Anordnung bei der die Auswirkung von Drift reduziert wird. Hierbei wird der Signal-Nullpegel **15** direkt in der Signalquelle **13** bei einer Störung ständig neu definiert und paßt sich laufend dem Drift **1** an.

Dies hat verglichen mit der Lösung in Figur 2 den Vorteil, daß sich die Grenzwerte des Meßwertes **4** nicht mehr zeitlich stark verändern können. Hier wird durch eine geeignete Schaltung (eine Vielzahl derartiger Schaltungen sind aus der Regelungstechnik bekannt) das tatsächliche Grundsignal, im folgenden auch mit nach-führbare Nullpunktspannung **15** bezeichnet, auf den Sollwert hin korrigiert. In der Korrektureinheit **12** erfolgt die Berechnung des neuen Mittelwertes durch Ermittlung der Abweichung in der Signalauswerteeinheit **3**. In die Korrektureinheit werden, sowohl das tatsächliche Signal nach dem Analog/Digitalwandler **5**, als auch der Sollwert des Nullpunkts **11** eingespeist und aus der Abweichung ein Mittelwert bestimmt. Dadurch ergeben das bereits in der Signalquelle **13** korrigierte Signal und der Sollwert des Signal-Nullpegels **11** in der Signalauswerteeinheit **3** zusammen einen vorzeichenbehafteten Meßwert **4**, dessen Dynamikgrenzen sich zeitlich nicht verändern.

Die Dimensionierung des Zeitbereiches, der für die Ermittelung des Ruhewertes in Frage kommt, läßt sich durch folgende Überlegungen eingrenzen. Da Signaturen aus dem Nutzbereich, die größer als z.B. 1Hz sind, keinen Einfluß nehmen sollen, ist der Zeitraum für die Ermittelung des Ruhewertes auf jeden Fall größer einer Sekunde anzusetzen. Die Ermittelung soll andererseits in Zeiträumen erfolgen, die eine kontinuierliche Nachführung an den driftenden Ruhewert erlaubt.

Geht man davon aus, daß Drifts nicht abrupt, sondern eher als Langzeiteffekt auftreten, so ist man im Minuten- oder noch größeren Bereich angelangt. Um einerseits die dynamische Offsetkorrektur nicht zu spät auszuführen und andererseits nicht auf ein Wirksignal zu reagieren ist ein Zeitraum von ca. 5 bis 30 Sekunden empfehlenswert.

Auch können verschiedene Mittelungsverfahren, wie bereits in den Beschreibungen von Figur 2 und 3 erwähnt, angewendet werden.

Im einstufigen Mittelungsverfahren wird die Meßgröße in z.B. einen digitalen 8-Bit-Wert abgebildet und über jeweils feste Zeitabschnitte in einem Integrator fester Wortbreite (z.B. 3 Bytes) aufsummiert. Nach Ablauf des Zeitabschnitts wird der Mittelwert als neuer (dynamischer) Nullpunkt verwendet.

Im mehrstufigen Mittelungsverfahren wird das einstufige Verfahren über mehrere Stufen ausgeführt, wobei der Meßwert der ersten Stufe als Meßgröße in die nachfolgende Stufe eingeht.

Im gleitend mittelnden Verfahren wird der Mittelwert auf folgende Weise gebildet:

$$\text{dyn. Nullpunkt(neu)} = \text{dyn. Nullpunkt(alt)} * (1-\varepsilon) + \varepsilon * \text{Meßwert(neu)}$$

Hierbei ist $\varepsilon$ eine kleine Zahl, vorzugsweise der Kehrwert einer Zweierpotenz, mit der sich die Reaktionszeit auf Änderungen einstellen läßt. Für den allerersten dyn. Nullpunkt (alt) wird entweder in einer Initiierungsroutine ein Mittelwert gebildet (falls keine Signatur beim Einschalten zu erwarten ist) oder es wird ein bei der Fertigung z.B. in ein EEProm eingetragener Ruhewert verwendet (im folgenden als eingetragener Ruhewert bezeichnet).

Für z.B. $\varepsilon = 2^{-16}$ und Meßwerten von 1 Byte ergibt sich z.B. unter Berücksichtigung einer endlichen Wortbreite folgendes Verfahren:

Man kann sich eine 3 Byte-Variable vorstellen, die mit dem eingetragenen Ruhewert in einem Speicher initialisiert ist, in den beiden nachfolgenden Bytes wird z.B. der Wert $8000 eingetragen.

Von dieser 3 Byte Zahl wird zu jedem Zyklus der Inhalt des Speichers abgezogen und der aktuelle Meßwert hinzuaddiert. Im Speicher steht nach der Einschwingdauer der tatsächliche Ruhewert.

Dieses Verfahren nähert sich nach einem Sprung des Nullpunkts in etwa exponentiell dem neuen Nullpunkt an.

Eine weitere Variante bildet die Darstellung des dynamischen Signal-Nullpegels durch einen Auf-/Abwärtszähler. In dieser Variante der dynamischen Offsetkorrektur wird dem Wegdritten der Ruhespannung wie folgt Rechnung getragen. Der Meßwert, ggf. bereits über eine gewisse Zeit gemittelt, wird mit dem aktuell gültigen dynamischen Nullpunkt verglichen. Diese Differenz geht wie folgt in einem Auf-/Abwärtszähler ein: Der Meßwert, ggf. bereits über eine gewisse Zeit gemittelt, wird mit dem Sollwert des Nullpunkts verglichen. Diese Differenz geht wie folgt in einem Auf-/Abwärtszähler ein: Liegt der dynamische Nullpunkt höher als der (ggf. gemittelte) Meßwert, so wird ein Zähler hochgezählt, liegt er niedriger, wird der Zähler heruntergezählt. Am Ende eines festen Zeitabschnitts wird dann bei einem Zählerstand über einem bestimmten positiven Wert die nachführbare Nullpunktspannung erniedrigt, bei einem Zählerstand unter einem bestimmten negativem Wert wird sie erhöht.

Die Reaktion auf einen Sprung der Ruhespannung ist hier ein linearer Anstieg des dynamischen Nullpunkts. Dieses Verfahren eignet sich auch besonders für die Nachführung/Korrektur der Nullpunktspannung nach Fig. 3.

**Patentansprüche**

1. Verfahren zur Reduzierung der Auswirkungen von Drift auf Signal-Nullpegel insbesondere bei Ansteuerungen von Insassen-Schutzsystemen, die aus einer Signalquelle und einer Signalauswerteeinheit bestehen, **dadurch gekennzeichnet, daß** aus dem ursprünglich statischen Signal-Nullpegel und dem Drift ein daraus zusammengesetztes Signal gebildet wird, welches als dynamischer Signal-Nullpegel in einer Signalquelle und/oder in einer Signalauswerteeinheit dient.

2. Verfahren nach Patentanspruch 1, **dadurch gekennzeichnet, daß** der dynamische Signal-Null-Pegel durch ein ein- oder mehrstufiges Mittelungsverfahren gebildet wird.

3. Verfahren nach Patentanspruch 1, **dadurch gekennzeichnet, daß** der dynamische Signal-Nullpegel durch ein gleitend mittelndes Verfahren gebildet wird.

4. Verfahren nach Patentanspruch 1, **dadurch gekennzeichnet, daß** der dynamische Signal-Nullpegel durch ein auf/abwärtszählendes Verfahren gebildet wird.

5. Verfahren nach einem der Ansprüche 1-4, **dadurch gekennzeichnet, daß** der dynamische Signal-Nullpegel durch eine Kombination des ein- oder mehrstufigen Mittelungsverfahren, des gleitenden mittelnden Verfahrens und/oder des auf/abwärtszählenden Verfahren gebildet wird.

6. Anordnung nach Patentanspruch 1, **dadurch gekennzeichnet, daß** der dynamische Signal-Nullpegel in Abhängigkeit von der Abweichung vom Sollwert korrigiert wird.

FIG. 1

FIG. 2

FIG. 3